(19) Europäisches Patentamt
European Patent Office
Office européen des brevets

(11) **EP 1 533 623 A2**

(12) **EUROPÄISCHE PATENTANMELDUNG**

(43) Veröffentlichungstag:
**25.05.2005 Patentblatt 2005/21**

(51) Int Cl.[7]: **G01R 31/08**, G01R 31/02

(21) Anmeldenummer: **05100754.0**

(22) Anmeldetag: **17.11.1999**

(84) Benannte Vertragsstaaten:
**AT CH DE FR GB IT LI**

(30) Priorität: **20.11.1998 AT 194698**

(62) Dokumentnummer(n) der früheren Anmeldung(en) nach Art. 76 EPÜ:
**99963307.6 / 1 131 642**

(71) Anmelder: **Adaptive Regelsysteme GmbH**
**5020 Salzburg (AT)**

(72) Erfinder: **Leikermoser, Albert**
**5020 Salzburg (AT)**

(74) Vertreter: **VA TECH Patente GmbH & Co**
**Penzinger Strasse 76**
**1141 Wien (AT)**

Bemerkungen:
Diese Anmeldung ist am 03 - 02 - 2005 als Teilanmeldung zu der unter INID-Kode 62 erwähnten Anmeldung eingereicht worden.

(54) **Verfahren zur Bestimmung eines erdschlussbehafteten Abzweiges**

(57) Es wird ein Verfahren zur Erfassung hochohmiger Erdfehler in sternpunktkompensierten elektrischen Verteilnetzen offenbart, das sich bei weitesgehender messtechnischer und gerätetechnischer Einfachheit durch eine hohe Verfahrenssicherheit auszeichnet, Erdfehler somit zuverlässig erkannt werden können. Ein solches Verfahren wird erfindungsgemäß dadurch erzielt, indem für die Abzweige i eine Differenznulladmittanz $Y_d(i)$ als Quotient aus der Differenz aus dem dem Abzweig zugeordneten Abzweignullstrom $i_0$ nach Erdschlusseintritt und dem Abzweignullstrom $i_0$ vor Erdschlusseintritt und der Differenz der Verlagerungsspannung $U_{ne}$ nach und vor dem Erdschlusseintritt ermittelt und ausgewertet wird.

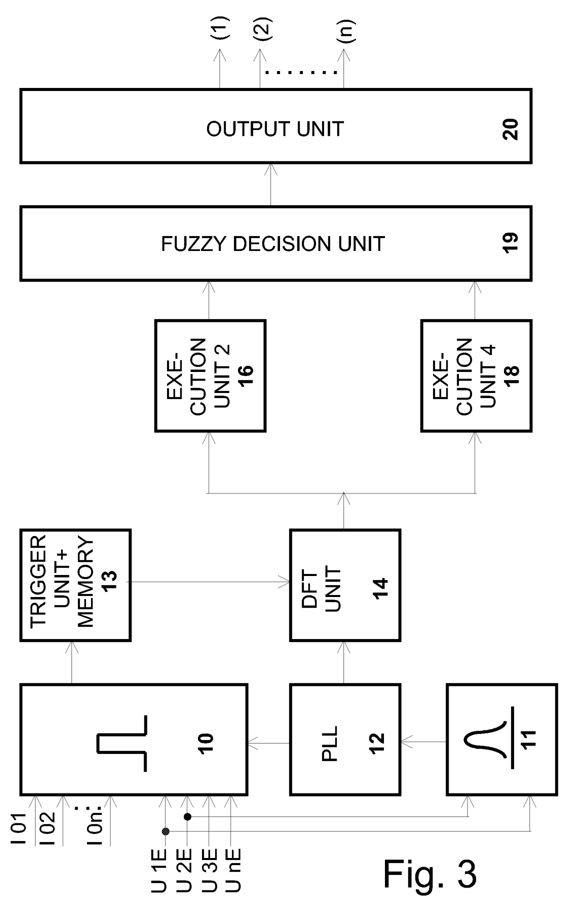


Fig. 3

EP 1 533 623 A2

Printed by Jouve, 75001 PARIS (FR)

## Beschreibung

Die vorliegende Erfindung bezieht sich auf ein Verfahren und eine Vorrichtung zur Bestimmung eines erdschlussbehafteten Abzweiges in einem induktiv sternpunktkompensierten elektrischen Stromversorgungsnetz, wobei als Messgrößen zumindest die Verlagerungsspannung oder die Summe der Phasen-Erdspannungen der einzelnen Phasen und die Nullströme aller Abzweige oder die Summe der einzelnen Phasenströme dieser Abzweige oder gleichwertige Messgrößen ausgewählt und gemessen werden.

Zur Bestimmung eines erdschlussbehafteten Abzweiges in einem gelöschten elektrischen Stromversorgungsnetz ist eine Anzahl von unterschiedlichen Verfahren bekannt, die z.B. in der WO92/18872, der EP 82103, der DE 27 11 629 oder der WO96/27138, aber auch in der Fachliteratur, z.B. Schutztechnik in elektrischen Netzen, VDE Verlag, ISBN 3-8007-1498-1, ausführlich beschrieben sind. Jedes dieser Verfahren hat jedoch bestimmte Nachteile, z.B. können mit einigen Verfahren keine kurzzeitigen Erdschlüsse erkannt werden, wogegen bei anderen Verfahren beispielsweise keine hochohmigen Erdschlüsse erkannt werden können.

Es ist daher eine Aufgabe der vorliegenden Erfindung, ein neuartiges Verfahren zu schaffen, bei welchem die Nachteile bekannter Verfahren vermieden werden und welches sich insbesondere durch eine besonders hohe Verfahrenssicherheit auszeichnet, bei welchem jedoch kein wesentlicher zusätzlicher gerätetechnischer Aufwand entsteht und folglich keine Mehrkosten verursacht werden. Insbesondere ist es ein Ziel der vorliegenden Erfindung, ein Verfahren zu schaffen, welches sich besonders für die Erfassung hochohmiger Erdfehler eignet.

Diese Aufgabe wird durch ein Verfahren gelöst, welches zur Bestimmung eines erdschlussbehafteten Abzweiges für die Abzweige eine Differenznulladmittanz als Quotient aus der Differenz aus dem dem Abzweig zugeordneten Abzweignullstrom nach Erdschlusseintritt und dem Abzweignullstrom vor Erdschlusseintritt und der Differenz der Verlagerungsspannung nach und vor dem Erdschlusseintritt ermittelt und ausgewertet wird.

Da sowohl der Zähler als auch der Nenner der Differenznulladmittanz aus einer Differenz kurzzeitig aufeinanderfolgender Messungen besteht, werden Fehler durch Fremdinduktionen auf den Verdrahtungsleitungen der Messeingänge weitgehend eliminiert. Bedingt durch die signifikante Erhöhung der Verlagerungsspannung im Erdschlussfall und die relativ kleine Verlagerungsspannung bei fehlerfreiem Netzbetrieb treten sowohl im Zähler als auch im Nenner vernünftig große Signaldifferenzen auf. Die in den Abzweignullströmen vorkommenden Unsymmetrieströme, bedingt durch kapazitive sowie ohmsche Unsymmetrien der drei Leiter gegen Erde (innere Unsymmetrien) sowie durch kapazitive Einkoppelungen, verursacht von parallelen Leitungsführungen (äußere Unsymmetrien), werden durch die Differenzbildung der Nullströme gänzlich eliminiert. Dadurch erhält man ein Verfahren, welches die Zuverlässigkeit und Verfahrenssicherheit erhöht. Bei dieser Anwendung können besonders hochohmige Erdschlüsse erkannt und einem bestimmten Abzweig zugeordnet werden. Als Messgrößen, welche durch die Methoden ausgewertet werden, sind zumindest die Sternpunkt-Erdspannung oder die Summe der Phasen-Erdspannungen der einzelnen Phasen und die Nullströme oder die Summe der einzelnen Phasenströme aller Abzweige oder gleichwertiger Messgrößen von besonderem Vorteil, da diese Messgrößen für eine Mehrzahl von unterschiedlichen Leitungsmodellen oder Auswertemethoden genutzt werden können.

Vorteilhafter Weise werden die Differenznulladmittanzen nur bezüglich der netzfrequenten Grundwellenanteile der Messwerte ermittelt, wobei die Grundwellenanteile vorzugsweise mit Hilfe der diskreten Fouriertransformation bzw. durch Fourierreihenentwicklung oder gleichwertige Methoden bestimmt werden.

Ein einfaches Verfahren zur Ermttlung der Fehlerhaftigkeit des Gesamtnetzes ergibt sich, wenn die Realteile der Differenznulladmittanz Y(i) aller Abzweige ermittelt werden und eine Erdschlussvermutung aufrecht bleibt, solange die Summe der Realteile der Differenznulladmittanzen über alle Abzweige negativ ist.

Vorteilhaft wird für einen Abzweig aus einer Größe, welche aus der Differenz des Realteils der Differenznulladmittanz für die netzfrequente Grundwelle und einem Schwellwert, welcher beispielsweise durch die Summe $g_r$ der Realteile der Differenznulladmittanzen über jene Abzweige, deren Realteil der Differenznulladmittanz positiv ist, gegebenenfalls unter Einbeziehung der Eisen- und/oder Kupfer verluste der Löschspule, gebildet und daraus ein Erfülltheitsgrad für das Vorliegen eines Erdschlusses ermittelt. Dazu wird vorteilhaft eine auf den Schwellwert normierte Distanzfunktion verwendet, die den Abstand zwischen dem Realteil und dem Schwellwert repräsentiert, aus der dann der Erfülltheitsgrad für das Vorliegen eines Erdfehlers ermittelt wird.

Um auch die Fehlerhaftigkeit von Ringschaltungen bzw. von einer andersartigen Vermaschung von Abzweigen erfassen zu können, werden im Fall, dass die Realteile der Differenznulladmittanzen mehrerer Abzweige negativ sind, die Summe dieser negativen Realteile für die Ermittlung des Erfülltheitsgrades herangezogen .

Nach dem Verstellen einer Löschspule oder einer andersartigen Änderung der Sternpunkt-Erdimpedanz, zum Beispiel zur Minimierung des Fehlerstromes an der Erdschlussstelle, kann für einen überwachten Abzweig oder Leitungsabschnitt vorteilhaft eine Differenznulladmittanz nach Impedanzänderung als Quotient aus der Differenz aus dem dem Abzweig zugeordneten Abzweignullstrom nach Änderung der Sternpunkt-Erdimpedanz im Erdschlussfall und dem Abzweignullstrom vor Erdschlusseintritt und der Differenz der Verlagerungsspannung nach Änderung der Sternpunkt-Erdimpedanz im Erdschlussfall und vor dem Erdschlusseintritt ermittelt werden, die ebenfalls zur Erfassung von

Erdschlüssen ausgewertet werden kann. Dazu wird vorteilhaft eine Admittanzdifferenz als Differenz aus der Differenznulladmittanz vor und der Differenznulladmittanz nach Änderung der Sternpunkt-Erdimpedanz ermittelt, aus der ein Erfülltheitsgrad für das Vorliegen eines Erdfehlers in einem Abzweig ermittelt werden kann.
Der Erfülltheitsgrad für das Vorliegen eines Erdschlusses kann beispielsweise aus den relativen Absolutbeträgen der Admittanzdifferenzen für diesen Abzweig bezüglich der netzfrequenten Grundwelle, z.B. bezogen auf die Summe der Beträge der Admittanzdifferenzen, ermittelt werden. Die Anwendung dieser Methode resultiert aus der Erkenntnis, dass sich bei einer Änderung der Verstimmung des gelöschten Gesamtnetzes, z.B. durch eine Verstellung der Tauchkernspule, der Fehlerstrom an der Erdschlussstelle und damit die Differenznulladmittanz vor und nach einer Änderung der Sternpunkt-Erdimpedanz ändert, während die Differenznulladmittanz fehlerfreier Abzweige vor und nach einer Änderung der Sternpunkt-Erdimpedanz unverändert bleibt.

Um die Zuverlässigkeit der Erkennung zu erhöhen , werden gegebenenfalls für die Abzeige die mit den beiden Verfahren ermittelten Erfülltheitsgrade durch eine zwei oder mehrwertige Logik, z.B. mit Methoden der Fuzzy Logic, zu einem Gesamterfülltheitsgrad verknüpft und nachfolgend für einen Abzweig ein Erdschluss angezeigt, wenn dieser Gesamterfülltheitsgrad einen bestimmten Wert überschreitet. Dazu kann auch das Vorliegen der Voraussetzungen für die Anwendung der jeweiligen Methode einbezogen werden, was vorteilhafter Weise in Form eines Erfülltheitsgrades für das Vorliegen der Voraussetzungen zur Anwendung dieser jeweiligen Methode berücksichtigt wird.
Durch diese logische Verknüpfung zumindest zweier unterschiedlicher Verfahren kann ein größerer Anwendungsbereich und über diesen Anwendungsbereich eine größere Verfahrenssicherheit realisiert werden, wobei die zwei Verfahren durch eine einzelne Einrichtung realisiert werden können, da im wesentlichen von denselben Messgrößen ausgegangen wird und/oder eine ähnliche Verarbeitung dieser Messgrößen möglich ist, so dass Synergien zwischen diesen Verfahren auftreten, die zu einer kostengünstigen und raschen Erkennung eines erdschlussbehafteten Abzweiges führen. Die Einbeziehung der Voraussetzungen für die Anwendbarkeit der einzelnen Methoden stellt sicher, dass keine falsche Interpretation von ausgewerteten Messwerten erfolgt, die das Gesamtergebnis verfälschen könnten. Die Erfülltheitsgrade für das Vorliegen eines Erdschlusses an einem einzelnen Abzweig, sowie gegebenenfalls der Gesamterfülltheitsgrad werden zweckmäßigerweise auf eins normiert, um eine einfache Handhabung der Daten zu gewährleisten. Die Anzahl der Abzweige, sowie die Anzahl der benutzten Methoden ist dabei beliebig. Zweckmäßigerweise werden auch die Erfülltheitsgrade für das Vorliegen der Verfahrensvoraussetzungen für die einzelnen Methoden auf eins normiert, um eine einfache Handhabung der Daten zu gewährleisten.
Bei einer vorteilhaften Ausgestaltung des erfindungsgemäßen Verfahrens ist die logische Verknüpfung durch Anwendung einer zwei oder mehrwertigen Logik, z.B. von Fuzzy Logic, realisiert. Durch den Einsatz dieser Logik zur Verknüpfung der Ergebnisse einzelner Verfahren kann gegenüber konventionellen Lösungen eine Verbesserung der Erkennung eines Erdschlusses und der sichereren Identifizierung des erdschlussbehafteten Abzweiges erreicht werden.

Bei einem Einsatz von Fuzzy Logic hat es sich als vorteilhaft erwiesen, wenn der Erfülltheitsgrad für das Vorliegen eines Erdschlusses, ermittelt anhand einer bestimmten Methode für einen bestimmten Abzweig, als eine durch eine erste Fuzzymenge repräsentierte linguistische Variable, z.B. "Abzweig n ist nach Methode j erdschlussbehaftet" und der Erfülltheitsgrad für das Vorliegen der Verfahrensvoraussetzungen für die jeweilige Methode als eine durch eine zweite Fuzzymenge repräsentierte linguistische Variable, z.B. "Verfahrensvoraussetzungen für Verfahren j sind erfüllt" definiert werden, und wenn die Entscheidung über das Vorliegen eines Erdschlusses durch eine Verknüpfung dieser Fuzzymengen mittels Fuzzy Logic getroffen wird.

Eine besonders scharfe Aussage über den Gesamterfülltheitsgrad für das Vorliegen eines Erdschlusses an einem bestimmten Abzweig kann durch Bildung des algebraische Produktes der über einen vorbestimmten Schwellwert liegenden Erfülltheitsgrade für das Vorliegen eines Erdschlusses über die einzelnen Methoden bestimmt werden. Eine vergleichsweise weichere Aussage über den Gesamterfülltheitsgrad für das Vorliegen eines Erdschlusses an einem bestimmten Abzweig kann durch das algebraische Mittel der mit den Verfahrenserfülltheitsgraden gewichteten Erfülltheitsgrade für das Vorliegen eines Erdschlusses der einzelnen Methoden ermittelt werden.

Für den Fall, dass die Annahme getroffen werden kann, dass zu einem bestimmten Zeitpunkt nur ein erdschlussbehafteter Abzweig vorliegt, kann das Ergebnis dadurch verbessert werden, dass jener Abzweig als erdschlussbehaftet angezeigt wird, für welchen der Gesamterfülltheitsgrad aller Abzweige am größten ist. Für den Fall, dass ein Ring oder ein vermaschtes Netz erdschlussbehaftet sind, können diese ebenso in obiger Weise als ein einzelner Abzweig behandelt werden.

Weiters werden die eingangs genannten Aufgaben durch eine Vorrichtung zur Bestimmung eines erdschlussbehafteten Abzweiges in einem sternpunktkompensierten elektrischen Stromversorgungsnetz gelöst, wobei die Auswerteeinheit eine Verarbeitungseinheit zur Messung und Auswertung der Messgrößen aufweist, wobei die Auswerteeinheit dazu eingerichtet ist, durch Ermittlung und Auswertung einer Differenznulladmittanz als Quotient aus der Differenz aus dem dem Abzweig oder Leitungsabschnitt zugeordneten , Abzweignullstrom nach Erdschlusseintritt und dem Abzweignullstrom vor Erdschlusseintritt und der Differenz der Verlagerungsspannung nach und vor dem Erdschlusseintritt für jeden Abzweig einen Erfülltheitsgrad für das Vorliegen eines Erdschlusses zu ermitteln. Die Erfülltheitsgrade aus zwei unterschiedlichen Auswertemethoden werden in einer Verknüpfungseinheit vorteilhaft zu einem Gesamterfülltheitsgrad logisch verknüpft.

Nachfolgend werden ohne Einschränkung der vorliegenden Erfindung zwei besonders vorteilhafte und erfinderische Methoden zur Bestimmung eines erdschlussbehafteten Abzweiges, sowie besonders vorteilhafte Beispiele zu deren logischen Verknüpfung und eine Vorrichtung zur Durchführung des erfindungsgemäßen Verfahrens im Detail beschrieben, wobei auf die beiliegenden Figuren 1, 2 und 3 Bezug genommen wird, von welchen

Figur 1 den Aufbau eines gelöschten (sternpunktkompensierten) elektrischen Versorgungsnetzes,
Figur 2 ein Leitungsmodell zur Nachbildung von Leitungen dieses Netzes und
Figur 3 ein Blockschaltbild für eine erfindungsgemäße Einrichtung zeigen.

Das in Figur 1 dargestellte Versorgungsnetz 1 weist eine dreiphasige Sammelschiene 2 auf, welche von einem Transformator 3 gespeist wird, dessen Sternpunkt über eine Löschdrossel 4, z.B. eine Tauchkernspule, deren Induktivität i.a. auf den Resonanzpunkt der Verlagerungsspannung $U_{ne}$ abgestimmt werden kann, geerdet ist, also ein gelöschtes bzw. induktiv sternpunktkompensiertes Versorgungsnetz. Verbraucherseitig sind an der Sammelschiene 2 oder mehrere Abzweige 1, 2, ... n angeschlossen, welche jeweils ohmsche g und kapazitive Ableitungen C, sowie Längswiderstände und -induktivitäten aufweisen. An der Phase $L_3$ des Abzweiges 1 ist am Ort x ein Erdschluss mit dem ohmschen Leitwert $g_k$ angedeutet, über welchen der Fehlerstrom $I_F$ fließt.

In Figur 2 ist das den Berechnungen zugrunde gelegte Leitungsmodell näher dargestellt. Zur Behandlung von einpoligen Erdschlüssen in gelöschten Mittel- und Hochspannungsleitungen ist es grundsätzlich notwendig, für die weiteren Betrachtungen ein geeignetes Modell (Ersatzschaltbild) der Leitung zu entwerfen. Die Struktur des Modells hängt stark vom betrachteten Frequenzspektrum ab. Grundsätzlich ist eine Leitung im gesamten Frequenzspektrum nur durch ein System mit verteilten Parametern beschreibbar.

Bei Einschränkung des Frequenzbereiches von 0 Hz bis ca. 400 Hz kann das Ersatzschaltbild gemäß Figur 2 als gute Näherung verwendet werden. Dieses Leitungsmodell enthält keine verteilten, sondern nur konzentrierte Elemente, deren physikalische Werte unabhängig von den fließenden Strömen bzw. Spannungen sind. Daher ist dieses Leitungsmodell auch linear. Diese Eigenschaft ist von grundlegender Bedeutung für die nachfolgenden Betrachtungen.

Zwecks Vereinfachung werden die Unsymmetrien der Leitungsgrößen auf den Leitungsanfang konzentriert. Ferner werden aufgrund der besseren Übersichtlichkeit die Lastwiderstände gleich und ohmsch (also ohne induktive oder kapazitive Komponenten) angenommen. Diese beiden Vereinfachungen haben jedoch keinen großen Einfluß auf das Ergebnis.

Die nachstehend beschriebenen Verfahren dienen einerseits zur Bestimmung des erdschlussbehafteten Abzweiges (Erdfehler einer Phase) und liefert andererseits Aussagen über das Vorhandensein eines Erdschlusses im gelöschten Gesamtnetz.

Die beschriebenen Verfahren setzen als Messgrößen die drei Phasen-Erdspannungen $U_{1e}$, $U_{2e}$, $U_{3e}$, oder die Sternpunkt-Erdspannung (oder Verlagerungsspannung) $U_{ne}$ und die Messung der Nullströme aller Abzweige ($I_{01}$, $I_{02}$, ..., $I_{on}$) oder als Ersatz für einen Abzweignullstrom die Summe der Phasenströme $i_1$, $i_2$, $i_3$ dieses Abzweigs voraus, gegebenenfalls in leicht abgewandelter Form, z.B. die Abtastung und Digitalisierung einer Messgröße in äquidistanten Zeitabständen, die Messung des netzfrequenten Grundwellenanteiles und/oder einer oder mehrerer Oberwellenanteile dieser Messgrößen in Betrag und Phase bezüglich einer (zeitlichen) Referenzgröße. Statt der Sternpunkt-Erdspannung bzw. Verlagerungsspannung $U_{ne}$ kann alternativ das arithmetische Mittel der drei Phasen-Erdspannungen $((D_{1e} + U_{2e} + U_{3e})/3)$ verwendet werden.

Sämtliche Messgrößen sind bezüglich einer (zeitlichen) Referenzgröße in Betrag und Phase oder in Form von Real- und Imaginärteil zu ermitteln.

Die nachstehend beschriebenen Verfahren sind nur auf eingeschwungene Systemzustände anwendbar. Die Fourierreihenzerlegung der gemessenen Ströme und Spannungen ergibt neben dem netzfrequenten Grundwellenanteil (50 Hz oder eventuell 60 Hz) Oberwellenanteile mit einem ungeradzahligen Vielfachen der Grundwellenfrequenz. Diese ungeradzahligen Oberwellen werden für die die Durchführung dieser Verfahren jedoch nicht benötigt.

Zweckmäßigerweise, aber nicht zwingend, werden die Grundwellen - sowie ungeradzahligen Obwellenanteile aller Messgrößen - mit Hilfe einer diskreten Fouriertransformation über ein ganzzahliges Vielfaches der Periodendauer der Grundwelle durchgeführt. Die verwendete Abtastfrequenz zur Messwertabtastung und nachfolgender Analog/Digitalwandlung sollte idealerweise ebenfalls ein ganzzahliges Vielfaches der Grundwellenfrequenz sowie der O-berwellenfrequenzen sein und im Kilohertzbereich liegen.

Die Rechenoperationen sind, sofern es sich um komplexe Größen handelt, auch komplex durchzuführen.

Im folgenden wird das erfindungsgemäße Verfahren, das sogenannte Wattmetrische Summenadmittanzverfahren, an Hand konkreter Verfahrensschritte im Detail beschrieben:

1.1. Vor dem Erdschlusseintritt werden, beispielsweise mit Hilfe der diskreten Fouriertransformation bzw. Fourierreihenentwicklung, die netzfrequenten Grundwellenanteile nachfolgender Messgrößen in Betrag und Phase bezüglich einer (zeitlichen) Referenzgröße bzw. als komplexe Größen kontinuierlich oder periodisch gemessen und bestimmt:

Die Verlagerungsspannung (Sternpunkt - Erdspannung) $U_{ne}(1)$ oder alternativ das komplexe arithmetische Mittel $((U_{1e}(1) + U_{2e}(1) + U_{3e}(1))\ /3)$ aus den Phasen - Erdspannungen.

Die Nullströme aller Abzweige $I_0(1)(1)$ bis $I_0(1)(n)$ (n-ter Abzweig) (die vor Erdschlusseintritt gemessenen Größen werden mit Index (1) gekennzeichnet).

1.2. Nach einer starken Änderung von $U_{ne}$ oder einer der Abzweignullströme $I_0$ wird eine Erdschlussvermutung ausgesprochen und mit dem nächsten Verfahrensschritt fortgesetzt, ansonsten wird der zuvor angeführte Verfahrensschritt wiederholt.

1.3. Nach dem Erdschlusseintritt werden, beispielsweise mit Hilfe der diskreten Fouriertransformation bzw. Forierreihenentwicklung, die netzfrequenten Grundwellenanteile nachfolgender Messgrößen in Betrag und Phase bezüglich einer (zeitlichen) Referenzgröße bzw. als komplexe Größen kontinuierlich oder periodisch gemessen und bestimmt:

Die Sternpunkt - Erdspannung $U_{ne}(2)$ oder alternativ das komplexe arithmetische Mittel $((U_{1e}(2) + U_{2e}(2) + U_{3e}(2))/3)$ der Phasen-Erdspannungen.

Die Nullströme aller Abzweige $I_0(2)(1)$ bis $I_0(2)(n)$ (die nach Erdschlusseintritt gemessenen Größen werden mit Index (2) gekennzeichnet).

1.4. Berechnung der "Differenznulladmittanzen" $Y_d(i)$ als Quotient des einem Abzweig zugeordneten Abzweignullstromes nach Erdschlusseintritt (Index 2) minus dem Abzweignullstrom vor Erdschlusseintritt (Index 1) geteilt durch die Differenz der Sternpunkt - Erdspannungen nach und vor dem Erdschlusseintritt.

Diese Differenznulladmittanz $Y_d(i)$ wird für jeden Abzweig (Index i) sowie für die netzfrequente Grundwelle berechnet.

Differenznulladmittanz für i-ten Abzweig:

$$Y_d(i) = (I_0(2)(i) - I_0(1)(i)) / (U_{ne}(2) - U_{ne}(1)) \tag{5}$$

mit:

| | |
|---|---|
| $I_0(1)(i)$ | Nullstrom i-ter Abzweig vor Erdschlusseintritt |
| $I_0(2)(i)$ | Nullstrom i-ter Abzweig nach Erdschlusseintritt |
| $U_{ne}(1)$ | Sternpunkt-Erdspannung vor Erdschlusseintritt |
| $U_{ne}(2)$ | Sternpunkt-Erdspannung nach Erdschlusseintritt |
| Index i | Abzweignummer |

Da sowohl der Zähler als auch der Nenner obiger Formel aus einer Differenz kurzzeitig aufeinanderfolgender Messungen besteht, werden Fehler durch Fremdinduktionen auf den Verdrahtungsleitungen der Messeingänge weitgehend eliminiert. Bedingt durch die signifikante Erhöhung der Sternpunkt-Erdspannung $U_{ne}$ im Erdschlussfall und die relativ kleine $U_{ne}$ bei fehlerfreiem Netzbetrieb treten sowohl im Zähler als auch im Nenner vernünftig große Signaldifferenzen auf. Die in den Abzweignullströmen $I_0$ vorkommenden Unsymmetrieströme, bedingt durch kapazitive sowie ohmsche Unsymmetrien der drei Leiter gegen Erde (innere Unsymmetrien) sowie durch kapazitive Einkoppelungen, verursacht von parallelen Leitungsführungen (äußere Unsymmetrien), werden durch die Differenzbildung der Nullströme gänzlich eliminiert. Zur Durchführung dieser Methode sind die Differenznulladmittanzen nur für die netzfrequenten Grundwellenanteile aller Abzweige zu bestimmen.

1.5. Bestimmung der Realteile der oben bestimmten "Differenznulladmittanzen" $Y_d(i)$

1.6. Berechnung der Summe der Realteile der "Differenznulladmittanzen" für die netzfrequenten Grundwellenanteile aller Abzweige mit Hilfe untenstehender Gleichung (6) für $g_l$,

$$g_l = \sum_{i=1}^{N} \mathrm{Re}\left(Y_d(i)\right), \tag{6}$$

wobei die Summe über alle Abzweige gebildet wird und $Re(Y_d(i))$ der Realteil der Differenznulladmittanz bezüglich der netzfrequenten Grundwelle für den i-ten Abzweig ist.

Ist $g_l$ negativ, so bleibt die Erdschlussvermutung aufrecht. Der Absolutbetrag von $g_l$ kann bei einer Ausführungsvariante mit einem, sich aus den Eisen- und/oder Kupferverlusten der Tauchkernspule ergebenden, im Erdschlussortungssystem parametrierten positiven Wert $g_e$, der unter Umständen von $U_{ne}$ abhängig ist, verglichen werden.

Ist $g_l$ positiv, so wird die Erdschlussvermutung verworfen (es liegt kein Erdschluss vor).

1.7. Berechnung der Summe der Realteile der "Differenznulladmittanzen" über jene Abzweige, deren Realteil der "Differenznulladmittanz" positiv ist, entsprechend nachfolgender Formel. Diese Summe wird mit $g_r$ bezeichnet,

$$g_r = \sum_{\substack{Abzweige \\ mit\ positivem \\ \mathrm{Re}(Yd(i))}} \mathrm{Re}\left(Y_d(i)\right) \qquad \textbf{(7)}$$

wobei die Summe über alle Abzweige mit positivem $Re(Y_d(i))$ gebildet wird und $Re(Y_d(i))$ der Realteil der Differenznulladmittanz bezüglich der netzfrequenten Grundwelle für den i-ten Abzweig ist.

1.8. Berechnung von $g_s$ als negative Summe von $g_r$ und $g_e$ laut nachfolgender Gleichung:

$$g_s = -(g_r + g_e) \qquad (8)$$

1.9. Nachfolgend werden die Realteile der "Differenznulladmittanzen" aller Abzweige mit dem (negativen) $g_s$ verglichen. Jener Abzweig, dessen Realteil seiner "Differenznulladmittanz" dem $g_s$ am nächsten liegt, wird als erdschlussbehaftet ausgewiesen. Dies wird aller Voraussicht nach jener sein, dessen Realteil der "Differenznulladmittanz" am negativsten von allen Abzweigen ist.

1.10. Sollten die Realteile der "Differenznulladmittanzen" zweier oder mehrerer Abzweige negativ sein und deren Summe nahe dem Schwellwert $g_s$ liegen, so liegt eine Ringschaltung bzw. Vermaschung dieser Abzweige vor und die beteiligten Abzweige können gemeinsam als erdschlussbehaftet ausgewiesen werden.

1.11. Die Erdschlussvermutung für einen Abzweig ist um so größer, je kleiner der Abstand seines Realteiles der "Differenznulladmittanz" von dem Schwellwert $g_s$ ist. Also ist es sinnvoll, eine normierte Distanzfunktion (Wahrscheinlichkeit, Erfüllungsgrad) einzuführen, die den Abstand dieser beiden Größen bezogen auf $g_s$ repräsentiert. Dies ist für jeden Abzweig zum Beispiel mittels der untenstehenden Gleichung für d(i) durchzuführen. Sind die Realteile der "Differenznulladmittanzen" mehrerer Abzweige negativ (liegt also eine Ringschaltung oder andere Art der Vermaschung mehrerer Abzweige vor), so ist die Summe der negativen Realteile zur Bildung der Distanzfunktion zu nehmen.

$$d(i) = abs(\,(Re(Y_d(i)) - g_s) / g_s) \qquad (8)$$

mit d(i): Absolutbetrag des Abstandes von $Re(Y_d(i))$ von $g_s$, geteilt (normiert) mit $g_s$ als Distanzmaß für den i-ten Abzweig.

Ist d(i) > 1, dann wird d(i) auf den Wert 1 gesetzt (begrenzt).

1.12. Als Erfülltheitsgrad p(i) der Aussage, das der i-te Abzweig erdschlussbehaftet ist, kann zum Beispiel die Differenz von eins minus der normierten Distanz d(i) entsprechend nachfolgender Formel verwendet werden. Gleiches gilt für Ringe oder andere Vermaschungen.

Erfülltheitsgrad für i-ten Abzweig: p(i) = 1 - d(i)

Im Anschluss wird eine weitere Methode zur Bestimmung eines erdschlussbehafteten Abzweiges, das sogenannte Nulladmittanzverfahren mit Spulenverstimmung, also mit Änderung der Sternpunkt-Erdimpedanz , im Detail beschrieben.

2.1. Nach Ausführung des obigen Verfahrens wird die Löschspule (Tauchkernspule), z.B. zur Minimierung des Fehlerstromes an der Erdschlussstelle, verfahren oder die Sternpunkt-Erdimpedanz in anderer Weise geändert. Die ursprüngliche Netzverstimmung v ändert sich somit um die Verstimmungsänderung dv.

2.2. Nach Durchführung der Spulenverstimmung oder einer andersartigen Änderung der Sternpunkt-Erdimpedanz im Erdschlussfall werden mit Hilfe der diskreten Fouriertransformation bzw. Fourierreihenentwicklung oder einer äquivalenten Methode die netzfrequenten Grundwellenanteile nachfolgender Messgrößen in Betrag und Phase bezüglich der (zeitlichen) Referenzgröße bzw. als komplexe Größen kontinuierlich oder periodisch gemessen und bestimmt:

Die Sternpunkt-Erdspannung $U_{ne}(3)$ oder alternativ das komplexe arithmetische Mittel der Phasen-Erdspannungen( $(U_{1e}(3) + U_{2e}(3) + U_{3e}(3))/3$) wird gemessen. Ebenso die Nullströme aller Abzweige $I_0(3)(1)$ bis $I_0(3)(n)$ (1......n-ter Abzweig) (die nach Spulenverstimmung bzw. Impedanzänderung im Erdschlussfall gemessenen Größen werden mit Index (3) gekennzeichnet).

2.3. Berechnung der "Differenznulladmittanzen nach Verstimmung" $Y_v(i)$ als Quotient des einem Abzweig zugeordneten Abzweignullstromes nach Spulenverstimmung bzw. Impedanzänderung im Erdschlussfall (Index 3) minus dem Abzweignullstrom vor Erdschlusseintritt (Index 1), geteilt durch die Differenz der Sternpunkt-Erdspannungen nach Spulenverstimmung bzw. Impedanzänderung im Erdschlussfall und vor Erdschlusseintritt (Index 3 bzw. Index 1).

Diese "Differenznulladmittanz nach Verstimmung" $Y_v(i)$ wird für jeden Abzweig (Index i) bezüglich der netzfrequenten Grundwelle berechnet.

Differenznulladmittanz nach Verstimmung $Y_v(i)$ für i-ten Abzweig bezüglich der netzfrequenten Grundwelle:

$$Y_v(i) = (I_0(3)(i) - I_0(1)(i)) / (U_{ne}(3) - U_{ne}(1)) \qquad (12)$$

mit:

| | |
|---|---|
| $I_0(1)(i)$ | Nullstrom i-ter Abzweig vor Erdschlusseintritt |
| $I_0(3)(i)$ | Nullstrom i-ter Abzweig nach Verstimmung bzw. Impedanzänderung im Erdschlussfall |
| $U_{ne}(1)$ | Sternpunkt-Erdspannung vor Erschlusseintritt |
| $U_{ne}(3)$ | Sternpunkt-Erdspannung nach Verstimmung bzw. Impedanzänderung im Erdschlussfall |
| Index i | Abzweignummer |

Da sowohl der Zähler als auch der Nenner obiger Formel aus einer Differenz kurzzeitig aufeinanderfolgender Messungen besteht, werden Fehler durch Fremdinduktionen auf den Verdrahtungsleitungen der Messeingänge weitgehend eliminiert. Bedingt durch die signifikante Erhöhung der Sternpunkt-Erdspannung $U_{ne}$ im Erdschlussfall und die relativ kleine $U_{ne}$ bei fehlerfreiem Netzbetrieb treten sowohl im Zähler als auch im Nenner vernünftig große Signaldifferenzen auf. Die in den Abzweignullströmen $I_0$ vorkommenden Unsymmetrieströme, bedingt durch kapazitive sowie ohmsche Unsymmetrien der drei Leiter gegen Erde (innere Unsymmetrien) sowie durch kapazitive Einkoppelungen, verursacht von parallelen Leitungsführungen (äußere Unsymmetrien), werden durch die Differenzbildung der Nullströme gänzlich eliminiert.

Zur Durchführung dieser Methode sind die "Differenznulladmittanzen nach Verstimmung" nur für die netzfrequenten Grundwellenanteile aller Abzweige zu bestimmen. Für die Durchführung von anderen, hier nicht dargestellten Verfahren, kann es sinnvoll sein, die Oberwellenanteile gleich mitzubestimmen.

2.4. Bestimmung der Admittanzdifferenzen DY(i) für die netzfrequenten Grundwellenanteile aller Abzweige als Subtraktion der "Differenznulladmittanz $Y_d(i)$" minus der "Differenznulladmittanz nach Verstimmung $Y_v(i)$" mittels der nachstehenden Gleichung:

$$DY(i) = (Y_d(i) - Y_v(i)) \qquad (13)$$

2.5. Die Herleitung des Verfahrens ergibt, dass die Admittanzdifferenzen für gesunde Abzweige null ergeben und für fehlerbehaftete Abzweige eine von null verschiedene Admittanzdifferenz liefern. Um mit reellen Größen weiterarbeiten zu können, ist es sinnvoll, die komplexe Admittanzdifferenz zum Beispiel durch Ihren Betrag als Maß (Fehlerfunktion) für die Abweichung von null zu repräsentieren. Dies wird für alle Abzweige mittels der Fehlerfunktion F(i) (i-ter Abzweig) entsprechend nachfolgender Formel durchgeführt:

$$F(i) := \|DY(i)\|$$

mit:

DY(i) Admittanzdifferenz für Grundwelle und i-ten Abzweig
F(i) Fehlerfunktion i-ter Abzweig als Betrag von DY(i)

2.6. Der Abzweig mit dem größten Fehler F(i) wird grundsätzlich als erdschlussbehaftet ausgewiesen.

2.7. Als Erfülltheitsgrad p(i) der Aussage, das der i-te Abzweig erdschlussbehaftet ist, kann zum Beispiel der Quotient von F(i) geteilt durch die Summe über die F(i) aller Abzweige verwendet werden.
Erfülltheitsgrad p(i) = F(i) / $F_s$

$$F_s := \sum_{i=1}^{N} F(i)$$

Nach Erdschlusseintritt werden prinzipiell mehrere unterschiedliche Methoden zur Bestimmung des erdschlussbehafteten Abzweiges angewendet. Diese Verfahren sollten sich in ihrer Methodik als auch in der Auswahl der Art der zu verarbeitenden Messgrößen sowie in ihrer Selektivität bezüglich verschiedenartiger Erdschlussphänomene unterscheiden.

Zusammenfassend werden die oben im Detail beschriebenen Verfahren nochmals kurz beschrieben:

Wattmetrisches Summenadmittanzverfahren: Diese Methode betrachtet nur die Grundwellenanteile (50 Hz, 60 Hz) der Messgrößen und setzt den eingeschwungenen (stationären) Systemzustand voraus. Die Ermittlung des erdschlussbehafteten Abzweiges erfolgt über die Ermittlung der Differenznulladmittanzen als Quotient von Nullstrom - und Spannungsdifferenzen mit nachfolgender Verifikation Ihrer Realteile. Die Herleitung zeigt, dass die Realteile der Differenznulladmittanzen fehlerfreier Abzweige oder Leitungsabschnitte positiv sind, während die Realteile der Differenznulladmittanzen fehlerhafter Abzweige oder Leitungsabschnitte einen negativen, durch $g_s$ aus Gleichung (7) festgelegten, Wert annehmen. Die weitere Ausführung des Verfahrens liefert als Ergebnis einen normierten, zwischen 0 und 1 liegenden, Erfülltheitsgrad der Erdschlussvermutung p(1,n) für alle N Abzweige mit n gleich 1 bis N.

Nulladmittanzverfahren mit Spulenverstimmung bzw. Änderung der Sternpunkt-Erdimpedanz: Das Verfahren beruht auf der Tatsache, dass die beim wattmetrischen Summenadmittanzverfahren beschriebenen Differenznulladmittanzen bezüglich der netzfrequenten Grundwellenanteile vor und nach einer Verstellung der Tauchkernspule bzw. einer Änderung der Sternpunkt-Erdimpedanz in erdschlussbehafteten Abzweigen einer Änderung unterliegen, während Sie bei gesunden Abzweigen durch die Spulenverstellung bzw. durch die Änderung der Sternpunkt-Erdimpedanz nicht beeinflußt werden. Durch Vergleich dieser Differenznulladmittanzen vor und nach einer Spulenverstellung bzw. durch eine Änderung der Sternpunkt-Erdimpedanz ist eine Aussage über das Vorliegen eines Erdschlusses auf dem betrachteten Abzweig möglich. Das Verfahren setzt einen eingeschwungenen (stationären) Systemzustand voraus.
Die Ausführung des Verfahrens liefert als Ergebnis einen normierten, zwischen 0 und 1 liegenden, Erfülltheitsgrad der Erdschlussvermutung p(2,n) für alle N Abzweige mit n gleich 1 bis N.

Jede der oben beschriebenen Methoden unterliegt bezüglich seiner Aussagekraft bestimmten Verfahrensvoraussetzungen. Nur wenn diese Voraussetzungen gegeben sind, kann das Verfahrensergebnis (Bestimmung des fehlerhaften Abzweiges) als aussagekräftig betrachtet werden. Ansonsten ist das Resultat zu verwerfen. Als Maß für die Aussagekraft (Gültigkeit) der einzelnen Verfahren wird eine, zwischen null und eins liegende, normierte Größe eingeführt, deren Wert die Voraussetzungen zur Verfahrensdurchführung beschreibt. Ist dieser "Erfülltheitsgrad der Verfahrensvoraussetzungen" pv(k) nahe 1, so kann auf das Verfahrensergebnis vertraut werden. Liegt dieser Wert nahe null, so sind die Voraussetzungen kaum erfüllt und das Ergebnis ist zu verwerfen.

Nachfolgend werden die, den obigen Verfahren zuzuordnenden Erfülltheitsgrade der Verfahrensvoraussetzungen für die zwei Methoden beispielhaft definiert und festgelegt.

Beim wattmetrischen Summenadmittanzverfahren ist die Höhe der Sternpunkt-Erdspannung (Verlagerungsspannung) $U_{ne}$ nach Erdschlusseintritt ein Maß für die Niederohmigkeit des Erdschlusses. Mit der Höhe der $U_{ne}$ steigt aber auch die Differenz der zu berechnenden Strom- und Spannungsdifferenzen und somit die numerische Konditionierung des Verfahrens. Daher kann zum Beispiel der Absolutbetrag der relativen Verlagerungsspannung $U_{ne}$ nach Erdschlusseintritt, bezogen auf die Nennspannung des Netzes, als Erfülltheitsmaß pv(1) der Verfahrensvoraussetzungen verwendet werden. Dieses Maß ist auf null zu setzen, wenn der Erdschluss nur transient war.

Beim Nulladmittanzverfahren mit Spulenverstimmung kann, analog zum wattmetrischen Summenadmittanzverfahren, zum Beispiel die mit der Phasennennspannung normierte Verlagerungsspannung $U_{ne}$ nach Erdschlusseintritt, gegebenenfalls gewichtet mit dem Ausmaß der Tauchkernspulenverstimmung, als Maß für die Erfülltheit pv(2) der Verfahrensvoraussetzungen definiert werden. Dieses Maß ist auf null zu setzen, wenn der Erdschluss nur transient war.

Die weiter oben definierten Erfülltheitsmaße p(j,n) für die Erdschlussvermutung des j-ten Verfahrens und n-ten Abzweiges können im Sinne der Fuzzy - Logik als Zugehörigkeitsfunktionen der, die linguistische Variable "Abzweig n ist nach Verfahren j erdschlussbehaftet" repräsentierenden, Fuzzymenge aufgefaßt werden.

Analog können die oben definierten Erfülltheitsmaße pv(j) für das j-te Verfahren im Sinne der Fuzzy - Logik als Zugehörigkeitsfunktionen der, die linguistische Variable "Verfahrensvoraussetzungen für das Verfahren sind erfüllt" repräsentierenden, Fuzzymenge aufgefaßt werden.

Zur logischen "UND" - Verknüpfung zweier linguistischer Variabler "A", "B" werden zum Beispiel die, den beiden Variablen zugehörigen, Fuzzy Mengen derart verknüpft, dass daraus eine neue, die linguistische Variable "A UND B" repräsentierende, Fuzzy-Menge entsteht. Dies geschieht durch Anwendung einer sogenannten T - Norm auf die zu den ursprünglichen Fuzzy - Mengen gehörenden Zugehörigkeitsfunktionen. Die einfachste "UND" Verknüpfung (T-NORM) der den linguistischen Variablen "A" sowie "B" zugehörigen Fuzzysets wird durch nachfolgende Operation der beiden Zugehörigkeitsfunktionen realisiert:

$$\mu(\text{A UND B}) = \min(\mu(\text{A}), \mu(\text{B}))$$

Das heißt, dass die der Fuzzy Menge "A UND B" entsprechende Zugehörigkeitsfunktion sich als Minimum der beiden, zu "A" sowie "B" gehörenden Zugehörigkeitsfunktionen ergibt.

Eine andere Möglichkeit der "UND" Verknüpfung ergibt sich durch Bildung des algebraischen Produktes der beiden Zugehörigkeitsfunktionen. Also:

$$\mu(\text{A und B}) = \mu(\text{A}) \;.\; \mu(\text{B})$$

Diese Art der "UND" Verknüpfung ergibt ein "trennschärferes UND".

Analog zum Minimum Operator für die UND Verknüpfung wird z.B. die "ODER" Verknüpfung bestimmt durch:

$$\mu(\text{A ODER B}) = \max\,(\mu(\text{A}), \mu(\text{B}))$$

Die der Fuzzy - Menge "NICHT A" entsprechende Zugehörigkeitsfunktion wird zum Beispiel folgendermaßen festgelegt:

$$\mu(\text{NICHT A}) = 1 - \mu(\text{A})$$

An dieser Stelle ist zu bemerken, dass dem Fachmann eine Vielzahl von Möglichkeiten für T - NORMEN ("UND" Verknüpfungen) und entsprechenden S - NORMEN ("ODER" Verknüpfungen) bekannt sind, die je nach Anwendungsfall eingesetzt werden können.

Die Entscheidungskriterien, nach denen der erdschlussbehaftete Abzweig zu bestimmen ist, können unterschiedlich formuliert werden. Nachfolgend werden zwei nicht einschränkende Beispiele vorgestellt, wie die Entscheidungslogik realisiert werden kann. Die Formulierung der Anforderungen an die Entscheidungslogik hängt auch von der in der Praxis gesammelten Erfahrungen ab.

Nachfolgend wird eine erste Variante mit sehr "harten" Entscheidungskriterien "Version 1" und eine zweite Variante "Version 2" mit eher weicheren und globaleren Eigenschaften beschrieben.

Version 1: Ausgehend von der Überlegung, dass jedes Verfahren ab einem gewissen Erfülltheitsgrad eine repräsentative Aussage über den fehlerhaften Abzweig liefern muß, kann als Gesamterfülltheitsgrad eines Abzweiges die logische "Verundung" über all jene verfahrensspezifischen Erfülltheitsgrade des gleichen Abzweiges durchgeführt werden, deren Erfülltheitsgrad der Verfahrensvoraussetzungen über einem Schwellwert $P_{lim}$ liegen.
Wird als T - NORM das algebraische Produkt verwendet, so folgt für den abzweigspezifischen Gesamterfülltheitsgrad pg(i) mit i gleich 1 bis N für die Abzweige 1 bis N:

$$pg(i) = \prod_{\substack{k\ mit \\ pv(k) > P\lim}} p(k,i)$$

Als erdschlussbehaftet wird jener Abzweig ausgewiesen, dessen pg(i) von allen N Abzweigen am größten (maximal) ist.

Version 2: Als Gesamterfülltheitsgrad der Erdschlussvermutung für einen Abzweig kann auch das mit den Verfahrenserfülltheitsgraden gewichtete arithmetische Mittel der Abzweigerfülltheitsgrade verwendet werden. Dies entspricht ganz allgemein der Überlegung, dass der erdschlussbehaftete Abzweig bezüglich aller Verfahren im Mittel generell höhere Erfülltheitsqrade aufweist. Dies gilt speziell dann, wenn die Verfahrensvoraussetzungen gut sind.

$$pg(i) = \left(\sum_{j=1}^{M} pv(j) \cdot P(j,i)\right) \Big/ \left(\sum_{j=1}^{M} pv(j)\right)$$

für i-ten Abzweig und für j = 1 bis M Verfahren

Darüber hinaus kann zum Beispiel als dritte Variante ein Zusammenhang mit beiden Versionen versucht werden, bei welcher der umgangssprachliche Begriff der "Eindeutigkeit des Ergebnisses" im Sinne der Fuzzy - Logik formuliert wird.

Der Begriff "eindeutig" im Kontext mit der Abzweigbestimmung läßt sich umgangssprachlich so formulieren: "Der und nur der Abzweig" weist einen hohen Erfülltheitsgrad auf. Statt " Der und nur der" läßt sich auch sagen "Dieser und kein anderer ...". Der Begriff "Dieser und kein anderer ...." kann auch in nachfolgender Weise ausgedrückt werden:

(Dieser) "UND" ("NICHT" der Erste der anderen)
"UND" ("NICHT" der Zweite der anderen)

usw.

Bei Verwendung des Minimumoperators als T - NORM und der oben dargestellten logischen Negation folgt für den, die Anforderung "Dieser und kein anderer ...." beschreibenden abzweigspezifischen Erfülltheitsgrad pe(i) für den i-ten Abzweig:

$$pe(i) = \min\big(pg(i), pc(i)\big)$$

mit

$$pc(i) = \min_{k \neq i}\big(1 - pg(k)\big) \Rightarrow pc(i) = \max_{k \neq i}\big(pg(k)\big)$$

folgt:

$$pe(i) = \min(pg(i), \max_{k \neq i}(pg(k)))$$

Die dargestellten Verfahren sollten nur als eine von vielen möglichen Ausführungsvarianten betrachtet werden.

In Figur 3 ist ein Blockschaltbild für ein nicht einschränkendes Ausführungsbeispiel zur Realisierung der erfindungsgemäßen Einrichtung dargestellt.

Die Einrichtung umfasst eine Abtasteinheit 10, mit welcher die oben beschriebenen, durch entsprechende bekannte Messeinrichtungen und Messwandler gelieferten analogen Messgrößen abgetastet und nachfolgend in digitale Werte konvertiert werden können, nämlich die von den Abzweigstromwandlern gelieferten Signale für die Nullströme $i_0$ aller Abzweige, die von den Spannungsmesswandlern kommenden Signale für die Phasen-Erdspannungen $U_{1e}$, $U_{2e}$, $U_{3e}$ und/oder das von der Spannungsmesswicklung der Löschspule (Tauchkernspule) oder einem zusätzlichen Spannungswandler gelieferte Signal für die Sternpunkt-Erdspannung $U_{ne}$ (Verlagerungsspannung).

Weiters ist eine, mit zumindest zwei Signalen für die Phasen-Erdspannung oder einem anderen netzfrequenten Referenzsignal verbundene, Synchronisiereinheit 11 vorgesehen, welche zur Bildung eines zeitlichen Referenzsignales als Phasenreferenz für die Abtasteinheit 10 eingerichtet ist. Diese Phasenreferenz wird an eine PLL-Einheit 12 (phase locked loop) geliefert, welche zur phasensynchronen Vervielfachung der Netzfrequenz dient und einerseits ein Ausgangssignal zur Abtastung der Messsignale an die Abtasteinheit 10, andererseits ein Ausgangssignal an eine DFT-Einheit 14 (digital fourier transformation) zur Fourierreihenentwicklung bzw. zur Fouriertransformation der abgetasteten und A/D konvertierten Messwerte liefert.

Die abgetasteten und A/D konvertierten Messwerte werden vorerst an eine Triggereinheit 13 übermittelt, in welcher die gemessenen Nullströme $i_0$ und die Verlagerungsspannung $U_{ne}$, bzw. die Phasen-Erdspannungen auf plötzliche Änderungen überwacht werden. Diese Triggereinheit 13 löst bei Überschreiten von vordefinierten Schwellwerten durch eine dieser Messgrößen einen verfahrensbedingt vorgesehenen Messwertaufzeichnungszyklus aus. Die aufgezeichneten Messzyklen werden in einem (nicht dargestellten) Speicher hinterlegt. Ferner ist die DFT Einheit 14 zwecks Bestimmung der Phasenbeziehungen der Meßgrössen bezüglich dem Referenzsignal über die PLL-Einheit 12 mit der Synchronisiereinheit 11 verbunden.

Die hinterlegten Messwerte werden sodann durch eine Anzahl von Auswerteeinheiten 16, 18 durch je eine Auswertemethode ausgewertet. Beispielsweise kann die Einheit 16 zur Durchführung der ersten oben beschriebenen Methode (Summenadmittanzverfahren) und die Einheit 18 zur Durchführung der zweiten oben beschriebenen Methode (Nulladmittanzverfahren mit Änderung der Sternpunkt-Erdimpedanz ) vorgesehen sein. Jede Einheit 16, 18 liefert im Fall einer getriggerten Aufzeichnung und Auswertung von Messgrößen, für jeden Abzweig i ein Ergebnis betreffend den Erfülltheitsgrad p(i) für das Vorliegen eines Erdschlusses an einem bestimmten Abzweig und ein weiteres Ergebnis für den Erfülltheitsgrad pv(i) für das Vorliegen der Voraussetzungen zur Anwendung des jeweiligen Verfahrens.

Diese Erfülltheitsgrade werden in der Folge beispielhaft in einer Einheit 19 durch eine mehrwertige Logik, z. B. eine Fuzzy Logic, zu einem aussagekräftigen Ergebnis (Gesamterfülltheitsgrad pg(i)) für jeden Abzweig i verarbeitet und an eine Ausgabeeinheit 20 weitergeleitet, welche z.B. eine Anzeige, einen Alarm, einen Notbetrieb, eine Abschaltung od. dgl. auslöst.

**Patentansprüche**

1. Verfahren zur Bestimmung eines erdschlussbehafteten Abzweiges in einem induktiv sternpunktkompensierten elektrischen Stromversorgungsnetz, wobei als Messgrößen zumindest die Verlagerungsspannung $U_{ne}$ oder die Summe der Phasen-Erdspannungen $U_{1e}$, $U_{2e}$, $U_{3e}$ der einzelnen Phasen $L_1$, $L_2$, $L_3$ und die Nullströme $i_0$ aller Abzweige oder die Summe der einzelnen Phasenströme $i_1$, $i_2$, $i_3$ dieser Abzweige oder gleichwertige Messgrößen ausgewählt und gemessen werden, **dadurch gekennzeichnet, dass** zur Bestimmung eines erdschlussbehafteten Abzweiges für die Abzweige i eine Differenznulladmittanz $Y_d$(i) als Quotient aus der Differenz aus dem dem Abzweig zugeordneten Abzweignullstrom $i_0$ nach Erdschlusseintritt und dem Abzweignullstrom $i_0$ vor Erdschlusseintritt und der Differenz der Verlagerungsspannung nach und vor dem Erdschlusseintritt ermittelt und ausgewertet wird.

2. Verfahren nach Anspruch 1, **dadurch gekennzeichnet, dass,** vorzugsweise mit Hilfe der diskreten Fouriertransformation bzw. Fourierreihenentwicklung, der netzfrequente Grundwellenanteil bezüglich einer Referenzgröße von der Verlagerungsspannung $U_{ne}$ oder alternativ des komplexen arithmetischen Mittels $(D_{1e} + U_{2e} + U_{3e})/3$ der Phasen-Erdspannungen $U_{1e}$, $U_{2e}$, $U_{3e}$ und der Nullströme $i_0$(i) der Abzweige i oder alternativ der Summen der einzelnen Phasenströme $i_1$, $i_2$, $i_3$ dieser Abzweige vor und nach einem Erdschluss in komplexer Weise oder in Betrag und Phase bestimmt wird und daraus die Differenznulladmittanz $Y_d$(i) ermittelt wird.

3. Verfahren nach Anspruch 1 oder 2, **dadurch gekennzeichnet, dass** ein Erdschluss vermutet wird, wenn sich die Verlagerungsspannung $U_{ne}$ oder einer der Abzweignullströme $i_0$ stark ändert.

4. Verfahren nach einem der Ansprüche 1 bis 3, **dadurch gekennzeichnet, dass** die Realteile der Differenznulladmittanz $Y_d$(i) ermittelt werden.

5. Verfahren nach Anspruch 4, **dadurch gekennzeichnet, dass** die Summe $g_l$ der Realteile der Differenznulladmittanzen $Y_d$(i) ermittelt wird.

**6.** Verfahren nach Anspruch 5, **dadurch gekennzeichnet, dass** die Erdschlussvermutung aufrecht bleibt, wenn die Summe $g_l$ der Realteile der Differenznulladmittanzen $Y_d$(i) negativ ist.

**7.** Verfahren nach einem der Ansprüche 1 bis 6, **dadurch gekennzeichnet, dass** jener Abzweig mit negativem oder bezüglich einem vorgebbaren Schwellwert negativerem Realteil seiner Differenznulladmittanz $Y_d$(i) bzw. mit negativstem Realteil seiner Differenznulladmittanz $Y_d$(i) als erdschlussbehaftet ausgewiesen wird.

**8.** Verfahren nach einem der Ansprüche 1 bis 7, **dadurch gekennzeichnet, dass** aus einer Größe, welche aus der Differenz des Realteils der Differenznulladmittanz bezüglich der netzfrequenten Grundwelle und einem Schwellwert $g_s$, welcher beispielsweise durch die Summe $g_r$ der Realteile der Differenznulladmittanzen $Y_d$(i) über jene Abzweige, deren Realteil der Differenznulladmittanz positiv ist, gegebenenfalls unter Einbeziehung der Eisen- und/ oder Kupferverluste der Löschspule $g_e$, gebildet wird, ein Erfülltheitsgrad für das Vorliegen eines Erdschlusses ermittelt wird

**9.** Verfahren nach Anspruch 8, **dadurch gekennzeichnet, dass** der Realteil der Differenznulladmittanz $Y_d$(i) der Abzweige i mit dem Schwellwert $g_s$ verglichen wird und die Erdschlussvermutung für einen Abzweig umso größer ist, je kleiner der Abstand seines Realteils zum Schwellwert $g_s$ ist.

**10.** Verfahren nach Anspruch 9, **dadurch gekennzeichnet, dass** eine auf den Schwellwert $g_s$ normierte Distanzfunktion d(i), die den Abstand zwischen dem Realteil und dem Schwellwert $g_s$ repräsentiert, verwendet wird.

**11.** Verfahren nach Anspruch 10, **dadurch gekennzeichnet, dass** als Erfülltheitsgrad p(i) für das Vorliegen eines Erdfehlers in einem Abzweig i die Differenz aus 1 und der normierten Distanz d(i) verwendet wird.

**12.** Verfahren nach einem der Ansprüche 8 bis 11, **dadurch gekennzeichnet, dass** im Fall dass die Realteile der Differenznulladmittanzen $Y_d$(i) mehrerer Abzweige negativ sind die Summe dieser negativen Realteile für die Ermittlung des Erfülltheitsgrades p(i) herangezogen wird.

**13.** Verfahren nach einem der Ansprüche 1 bis 3, **dadurch gekennzeichnet, dass** eine Löschspule, z.B. zur Minimierung des Fehlerstromes an der Erdschlussstelle, verstellt wird oder die Sternpunkt-Erdimpedanz auf eine andere Weise verändert wird und nach der Spulenverstimmung, bzw. nach Impedanzänderung, eine Differenznulladmittanz nach Verstimmung $Y_v$(i) als Quotient aus der Differenz aus dem dem Abzweig zugeordneten Abzweignullstrom $i_0$ nach Spulenverstimmung im Erdschlussfall und dem Abzweignullstrom $i_0$ vor Erdschlusseintritt und der Differenz der Verlagerungsspannung $U_{ne}$ nach Spulenverstimmung, bzw. nach Impedanzänderung, im Erdschlussfall und vor dem Erdschlusseintritt ermittelt wird.

**14.** Verfahren nach Anspruch 13, **dadurch gekennezeichnet, dass** eine Admittanzdifferenz DY(i) als Differenz aus Differenznulladmittanz $Y_d$(i) und der Differenznulladmittanz nach Verstimmung $Y_v$(i) ermittelt wird.

**15.** Verfahren nach Anspruch 14, **dadurch gekennzeichnet, dass** ein fehlerhafter Abzweig i erkannt wird, wenn dessen Admittanzdifferenz DY(i) von Null verschieden ist.

**16.** Verfahren nach Anspruch 14 oder 15, **dadurch gekennzeichnet, dass** eine Fehlerfunktion F(i) berechnet wird, vorzugsweise als Betrag der Admittanzdifferenz DY(i), und der Abzweig i mit dem größten Fehler F(i) als erdschlussbehaftet ausgewiesen wird oder jeder Abzweig i als fehlerhaft ausgewiesen wird, dessen Fehlerfunktion F(i) größer als Null ist.

**17.** Verfahren nach Anspruch 16, **dadurch gekennzeichnet, dass** als Erfülltheitsgrad p(i) für das Vorliegen eines Erdfehlers in einem Abzweig i der Quotient aus Fehlerfunktion F(i) und der Summe aller Fehlerfunktionen verwendet wird.

**18.** Verfahren nach einem der Ansprüche 1 bis 17, **dadurch gekennzeichnet, dass** für die Abzeige i die mit den beiden Verfahren ermittelten Erfülltheitsgrade p(i) durch eine zwei oder mehrwertige Logik, z.B. von Fuzzy Logic, zu einem Gesamterfülltheitsgrad pg(i) verknüpft werden und für einen Abzweig i ein Erdschluss angezeigt wird, wenn dieser Gesamterfülltheitsgrad einen bestimmten Wert überschreitet.

**19.** Verfahren nach Anspruch 18, **dadurch gekennzeichnet, dass** zur logischen Verknüpfung der Erfülltheitsgrade p (i) zu einem Gesamterfülltheitsgrad pg(i) zusätzlich das Vorliegen der Voraussetzungen für die Anwendung der

beiden Methoden einbezogen werden.

**20.** Verfahren nach Anspruch 19, **dadurch gekennzeichnet, dass** zu dem durch die beiden Methoden ermittelten Erfüllltheitsgrad p(i), welche den Erfüllltheitsgrad p(i) für das Vorliegen eines Erdschlusses an einem bestimmten Abzweig i anhand einer bestimmten Methode darstellt, auch ein Erfüllltheitsgrad pv(i) für das Vorliegen der Voraussetzungen zur Anwendung dieser Methode ermittelt wird.

**21.** Verfahren nach einem der Ansprüche 18 bis 20, **dadurch gekennzeichnet, dass** jener Abzweig als erdschlussbehaftet angezeigt wird, für welchen der Gesamterfüllltheitsgrad pg(i) aller Abzweige i am größten ist.

**22.** Vorrichtung zur Bestimmung eines erdschlussbehafteten Abzweiges in einem gelöschten elektrischen Stromversorgungsnetz mit einer Einrichtung zum Messen physikalischer Messgrößen und einer Auswerteeinheit zur Auswertung dieser Messgrößen, wobei die Auswerteeinheit eine Anzeigeeinrichtung aufweist, **dadurch gekennzeichnet, dass** die Auswerteeinheit (10, 11, 12, 13, 14, 16, 18, 19) eine Verarbeitungseinheit (16, 18) zur Auswertung der Messgrößen aufweist, wobei die Auswerteeinheit dazu eingerichtet ist, durch Ermittlung und Auswertung einer Differenznulladmittanz $Y_d(i)$ als Quotient aus der Differenz aus dem dem Abzweig zugeordneten Abzweignullstrom $i_0$ nach Erdschlusseintritt und dem Abzweignullstrom $i_0$ vor Erdschlusseintritt und der Differenz der Verlagerungsspannung nach und vor dem Erdschlusseintritt für jeden Abzweig i einen Erfüllltheitsgrad p(i) für das Vorliegen eines Erdschlusses zu ermitteln.

**23.** Vorrichtung nach Anspruch 22, **dadurch gekennzeichnet, dass** die Auswerteeinheit (10, 11, 12, 13, 14, 16, 18, 19) zumindest zwei Verarbeitungseinheiten (16, 18) zur Auswertung der Messgrößen mittels zweier unterschiedlichen Auswertemethoden aufweist, wobei jede Verarbeitungseinheit dazu eingerichtet ist, für jeden Abzweig i einen Erfüllltheitsgrad p(i) für das Vorliegen eines Erdschlusses zu ermitteln, und dass die Auswerteeinheit (10, 11, 12, 13, 14, 16, 18, 19) weiters eine Verknüpfungseinheit (19) zur logischen Verknüpfung der aus der ersten und der zweiten Verarbeitungseinheit (16, 18) gelieferten Erfüllltheitsgrade p(i) zu einem Gesamterfüllltheitsgrad pg(i) aufweist.

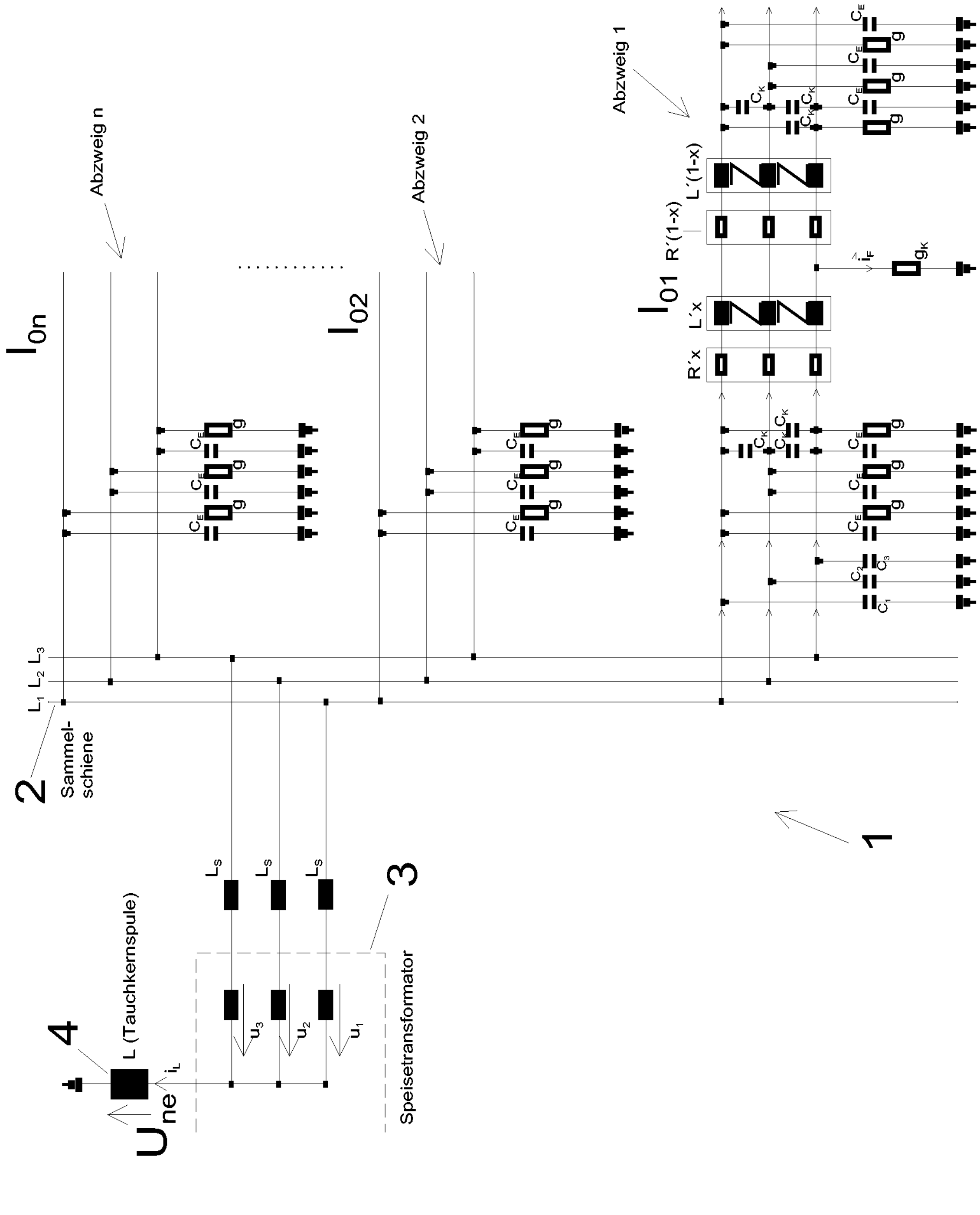
Abzweig n
Abzweig 2
Abzweig 1
$I_{0n}$
$I_{02}$
$I_{01}$
L´(1-x)
R´(1-x)
L´x
R´x
$i_F$
$g_K$
$C_E$
g
$C_K$
$C_1$
$C_2$
$C_3$
$L_1$ $L_2$ $L_3$
2
Sammel-
schiene
1
3
$L_S$
$u_1$
$u_2$
$u_3$
Speisetransformator
4
L (Tauchkernspule)
$i_L$
$U_{ne}$

Fig. 1

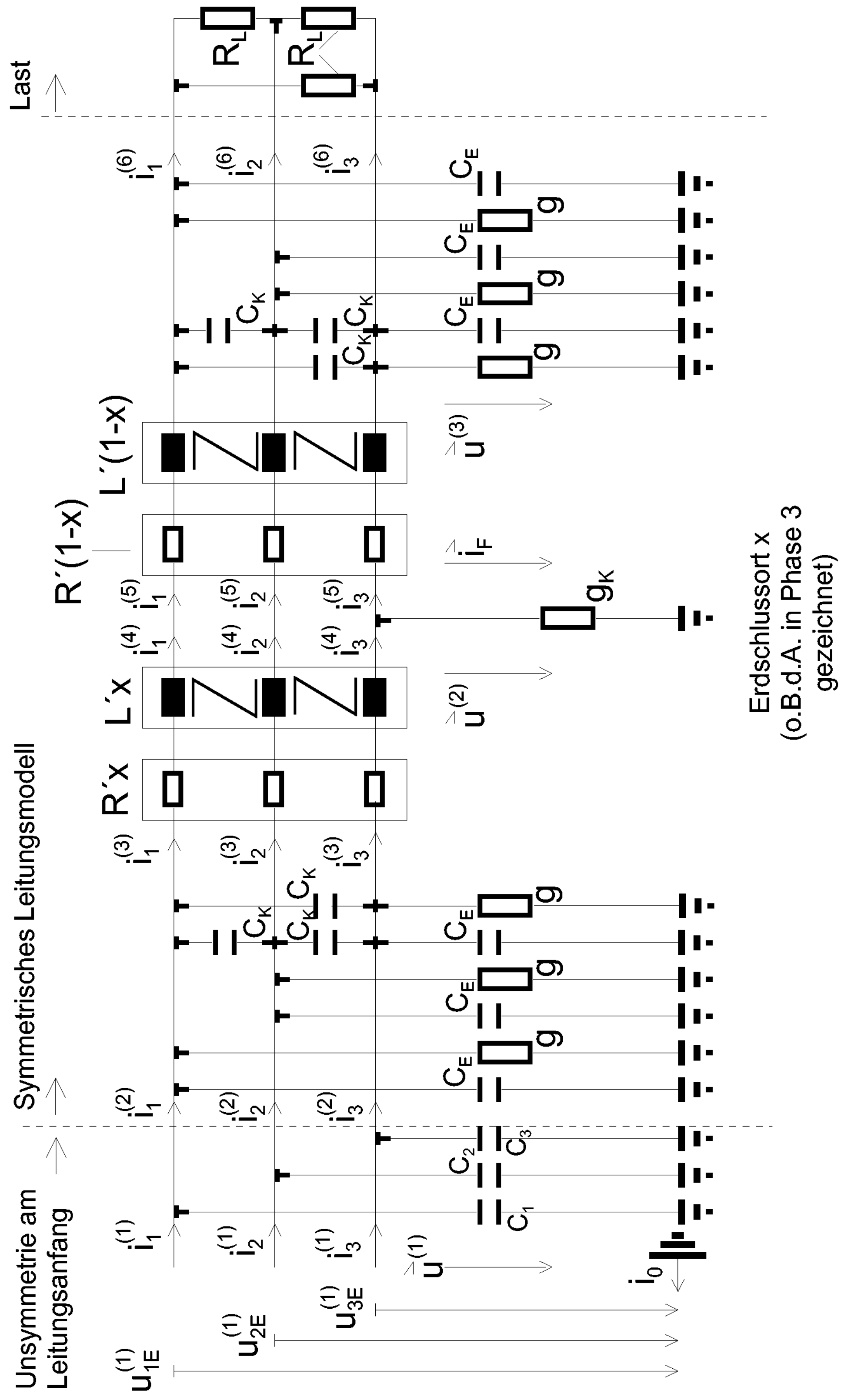
Unsymmetrie am Leitungsanfang
Symmetrisches Leitungsmodell
Last
R´x
L´x
R´(1-x)
L´(1-x)
Erdschlussort x (o.B.d.A. in Phase 3 gezeichnet)


Fig. 2

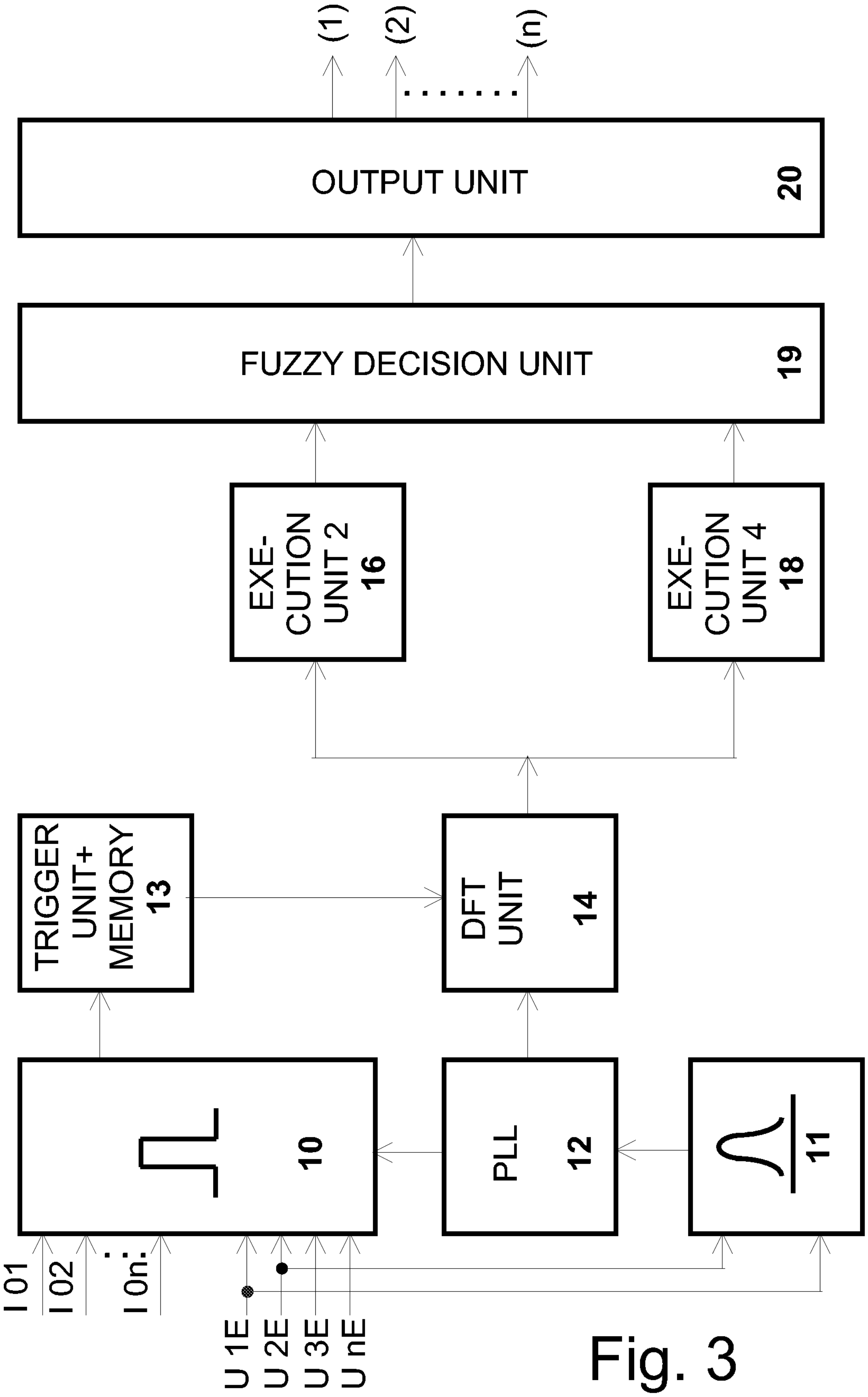
(1)
(2)
(n)
OUTPUT UNIT
20
FUZZY DECISION UNIT
19
EXE-CUTION UNIT 2
16
EXE-CUTION UNIT 4
18
TRIGGER UNIT+ MEMORY
13
DFT UNIT
14
10
PLL
12
11
I 01
I 02
I 0n
U 1E
U 2E
U 3E
U nE

Fig. 3